(19) Europäisches Patentamt
European Patent Office
Office européen des brevets

(11) **EP 1 677 396 B1**

(12) **EUROPÄISCHE PATENTSCHRIFT**

(45) Veröffentlichungstag und Bekanntmachung des Hinweises auf die Patenterteilung:
**03.01.2007 Patentblatt 2007/01**

(51) Int Cl.:
***H01S 5/12*** *(2006.01)*

(21) Anmeldenummer: **04090518.4**

(22) Anmeldetag: **28.12.2004**

(54) **BH-DFB-Laser mit getapertem optischen Wellenleiter**

BH-DFB-Laser with tapered optical waveguide

Laser du type BH-DFB à guide d'onde optique en forme conique

(84) Benannte Vertragsstaaten:
**AT BE BG CH CY CZ DE DK EE ES FI FR GB GR HU IE IS IT LI LT LU MC NL PL PT RO SE SI SK TR**

(43) Veröffentlichungstag der Anmeldung:
**05.07.2006 Patentblatt 2006/27**

(73) Patentinhaber: **Fraunhofer-Gesellschaft zur Förderung der angewandten Forschung e.V.
80686 München (DE)**

(72) Erfinder: **Möhrle, Martin, Dr. Dipl.-Phys.
12683 Berlin (DE)**

(56) Entgegenhaltungen:
**DE-A1- 19 500 135**

- **PATENT ABSTRACTS OF JAPAN Bd. 1999, Nr. 13, 30. November 1999 (1999-11-30) & JP 11 220220 A (MATSUSHITA ELECTRIC IND CO LTD), 10. August 1999 (1999-08-10)**
- **HARTMUT HILLMER ET AL: "CONTINUOUSLY CHIRPED DFB GRATINGS BY SPECIALLY BENT WAVEGUIDESS FORTUNABLE LASERS" JOURNAL OF LIGHTWAVE TECHNOLOGY, IEEE. NEW YORK, US, Bd. 13, Nr. 9, 1. September 1995 (1995-09-01), Seiten 1905-1912, XP000541885 ISSN: 0733-8724**
- **EPLER J: "SINGLE MODE INDEX GUIDED DISTRIBUTED FEEDBACK LASER" XEROX DISCLOSURE JOURNAL, XEROX CORPORATION. STAMFORD, CONN, US, Bd. 16, Nr. 4, 1. Juli 1991 (1991-07-01), Seiten 265-266, XP000225938**

**Beschreibung**

Die Erfindung betrifft einen Buried-Heterostructure (BH)-Distributed Feedback (DFB) Laser mit getapertem optischen Wellenleiter zur optischen Feldaufweitung an der Frontfacette, der mindestens aus einem vergrabenen optischen Wellenleiter mit eingebauter aktiver Schicht auf einem Substrat sowie einem integrierten Diffraktionsgitter besteht.

Bei solchen BH-DFB-Lasern ändert sich der effektive Brechungsindex in longitudinaler Richtung von der Taperspitze (kleiner effektiver Brechungsindex) zum Taperende (größerer effektiver Brechungsindex). Bei Verwendung eines uniformen DFB-Gitters ergeben sich dadurch längs der Laserstruktur lokal unterschiedliche Bragg-Wellenlängen, was dann zu einer Reduktion der Single-Mode-Ausbeute solcher Laser und bei großem Brechungsindexunterschied zwischen Taperspitze und Taperende zu einem Multi-Moden-Betrieb der Laser führt.

Bekannt sind BH-DFB-Laser mit getaperter aktiver Schicht in drei Bauformen:

- In Kombination mit einem uniformen gain-gekoppelten DFB-Gitter wurden entsprechende Laser von Kitoh et al., "High Slope Efficiency and Low Noise Characteristics in Tapered-Active-Stripe DFB Lasers with Narrow Beam Divergence", IEEE J. of QE, vol. 35, pp 1765-1770, 1999 [1] vorgestellt. Durch Verwendung einer speziellen aktiven Schicht mit sehr kleiner Brechungsindexänderung entlang des Lasers ($\Delta n = 0{,}01$) wird eine lokale Variation der DFB-Wellenlänge längs des Lasers erreicht. Mit vorderseitig entspiegelten und rückseitig verspiegelten Lasern wird ein Single-Mode-Betrieb des Lasers erreicht.

- In Kombination mit einem uniformen index-gekoppelten DFB-Gitter wurden entsprechende Laser von Grillot et al. "Analysis, Fabrication, and Characterization of 1.55-$\mu$m Selection-Free Tapered Stripe DFB Lasers", IEEE Photon. Techn. Letters, vol. 14, pp 1040-1042, 2002 [2] vorgestellt. Eine spezielle getaperte aktive Schicht mit einem kleinen Streifenbreitenunterschied zwischen Taperspitze und Taperende (geringfügige Änderung des effektiven Brechungsindexes) wird hier ausgenutzt, um eine lokale Variation der DFB-Wellenlänge längs des Lasers zu erreichen. Die Taperung der aktiven Schicht dient hier nicht dazu, das optische Feld aufzuweiten. Mit beidseitig entspiegelten Lasern wird ein Single-Mode-Betrieb der Laser erreicht.

- In Kombination mit einer an den lokalen Brechungsindexverlauf angepassten Gitterperiode (kontinuierlich gechirptes Gitter), mit dem Ziel einer effektiv konstanten DFB-Wellenlänge längs des Lasers, wurden von Kitoh et al. konkrete Anordnungen im US-Patent 6,104,738 (Aug. 15, 2000) beschrieben [3]. Realisiert wurden solche Laser erstmals von Möhrle et al., beschrieben in IEEE Photon. Techn. Letters, vol. 15, No. 3, pp 365-367, 2003 [4]. Mit vorderseitig entspiegelten Lasern wurde ein Single-Mode-Betrieb der Laser erreicht.

Bekannt ist weiterhin eine BH-DFB-Laser-Bauform mit einem gekrümmten Wellenleiter, die von Hillmer et al. "Continuously Chirped DFB Gratings by Specially Bent Waveguides for Tunable Lasers" J. of Lightwave Technology, vol. 13, pp 1905-1912, 1995 [5] vorgestellt wurde, bei der eine Änderung der Gitterperiode durch Verwendung gekrümmter Wellenleiter erreicht wurde. In diesem Fall werden gekrümmte Wellenleiter verwendet, um gezielt eine lokale Variation der DFB-Wellenlänge längs der Laserstruktur zu erreichen. Es handelt sich hierbei nicht um DFB-Laser mit einer getaperten aktiven Schicht zur Aufweitung des optischen Feldes an der Frontfacette.

Andere Bauformen von DFB-Lasern mit zusätzlich integrierten passiven oder aktiven Tapern zur Feldaufweitung an der Frontfacette sind aus der Literatur bekannt. Dadurch ist die Baulänge dieser Laser groß und die Herstellungstechnologie aufwändig.

Alle bisher bekannten DFB-Laser mit getaperter aktiver Schicht benötigen zur Vermeidung von Fabry-Perot-Resonanzen und zum Erreichen eines Single-Mode-Betriebes mindestens die Entspiegelung der Frontfacette. Da diese Entspiegelung an jedem einzelnen Laserbarren eines Wafers vorgenommen werden muss, ist dieser Technologieschritt mit hohen Zusatzkosten verbunden.

Die Herstellung von kontinuierlich gechirpten Gittern mit einer an den lokalen Brechungsindexverlauf angepassten Gitterperiode [3, 4] mit dem Ziel einer effektiv konstanten DFB-Wellenlänge längs des Lasers mittels Elektronenstrahllithographie ist zwar möglich, kann jedoch prinzipbedingt nur mit sehr langen Schreibzeiten realisiert werden. Die Belichtung eines vollständigen Wafers mit solchen DFB-Lasern würde mehrere Tage in Anspruch nehmen. Eine kostengünstige Herstellung von getaperten DFB-Lasern ist auf diese Weise nicht möglich. Außerdem müssen auch solche Laser noch mindestens vorderseitig entspiegelt werden.

Aufgabe der Erfindung ist, einen BH-DFB-Laser-Typ mit getapertem optischen Wellenleiter zur optischen Feldaufweitung an der Frontfacette vorzuschlagen, der unterschiedliche Bauformen ermöglicht und mit verschiedenen Materialien und Heterostrukturen realisiert und dessen DFB-Gitter mittels Elektronenstrahllithographie oder Holographie kostengünstig hergestellt werden kann und der ohne zusätzliche Beschichtung der Facetten im Single-Mode-Betrieb arbeitet.

Die Aufgabe wird für einen BH-DFB-Laser der eingangs genannten Art dadurch gelöst, dass erfindungsgemäß das Diffraktionsgitter eine konstante Gitterperiode aufweist und der Wellenleiter mit eingebauter aktiver Schicht derart gekrümmt ausgebildet ist, dass die effektive Gitterperiode $\Lambda_{\text{eff}}$ (x) des Diffraktionsgitters für die durchlaufende optische Welle an den lokalen Brechungsindexverlauf $n_{eff}$ (x) gemäß der Bedingung

$$\Lambda_{eff} (x) = \lambda / 2\, n_{eff} (x)$$

angepasst ist, wobei $\Lambda_{eff}$ die effektive Gitterperiode, $\lambda$ die Emissionswellenlänge und $n_{eff}$ der Brechungsindex ist. Die Heterostruktur sowie die Taperung des optischen Wellenleiters sind dabei so ausgeführt, dass der entstehende Winkel zwischen Frontfacette und Verlauf der aktiven Schicht für eine Entspiegelung dieser Facette ausreicht.

In der erfindungsgemäßen Lösung wird damit anstelle einer lokalen Anpassung der Gitterperiode (gechirptes Gitter), die technologisch sehr aufwändig ist, der getaperte optische Wellenleiter aus vergrabenem Wellenleiter mit eingebauter aktiver Schicht auf einem Substrat sowie einem integrierten Diffraktionsgitter mit einer definierten Krümmung versehen, so dass die wirksame effektive Gitterperiode für die durchlaufende optische Welle dem eines gechirpten Gitters entspricht. Damit ist an jedem Ort des Lasers die Bragg-Bedingung, nämlich eine konstante effektive DFB-Wellenlänge längs des Lasers, für die DFB-Wellenlänge erfüllt.

Heterostruktur, aufweisend optische Wellenleiter und aktive Schicht, und Taperung des optischen Wellenleiters werden dabei so gewählt, dass der entstehende Winkel zwischen Frontfacette und Verlauf der aktiven Schicht für eine Entspiegelung dieser Facette ausreicht. Dabei erfüllt der integrierte gekrümmte Taper zwei unterschiedliche Funktionen. Er dient zum einen dazu, das optische Feld an der Frontfacette mit dem Ziel einer verbesserten Einkopplung des Laserlichtes in die optische Glasfaser aufzuweiten, zum anderen wird in Kombination mit der entspiegelten Frontfacette eine Modenselektion erreicht. Hin- und rücklaufende DFB-Lasermoden sind aufgrund der gekrümmten getaperten aktiven Schicht und der entspiegelten Frontfacette (unsymmetrische Laserstruktur) nicht mehr gleichwertig. Dies führt zu einer Unterdrückung der kurzwelligen DFB-Mode, so dass der Laser ausschließlich auf der langwelligen DFB-Mode emittiert, wodurch ein stabiler Single-Mode-Betrieb gewährleistet ist. Die kostenintensive Selektion von Single-Mode-Lasern nach der Prozessierung und Entspiegelung der DFB-Laser entfällt hier.

Ein weiterer Vorteil der erfindungsgemäßen Lösung besteht darin, dass getaperte BH-DFB-Laser hergestellt werden können, bei denen nur ungechirpte Gitter, d.h. Gitter mit einer konstanten Gitterperiode, belichtet werden müssen, was mittels Elektronenstrahllithographie oder Holographie problemlos und kostengünstig durchgeführt werden kann. Eine zusätzliche vorderseitige Entspiegelung des Lasers entfällt durch die Schrägstellung der Frontfacette.

Die Vorteile der bekannten BH-DFB-Laser mit lateral getaperter aktiver Schicht gelten auch für den erfindungsgemäßen BH-DFB-Laser. Durch die Integration eines Tapers wird eine Aufweitung des optischen Feldes an der Austrittsfacette erreicht. Dies führt zu einer Reduzierung der Einkoppelverluste in die optische Glasfaser. Die Taperung der aktiven Schicht selbst erlaubt eine kurze Bauform (L < 500 $\mu$m) der Laser, was zu einer kostenreduzierenden großen Ausbeute von Lasern pro prozessiertem Wafer führt.

In Ausgestaltungen weist der erfindungsgemäße BH-DFB-Laser ein index-gekoppeltes Gitter, insbesondere mit einem Phasensprung oder mehreren Phasensprüngen oder ein gain-gekoppeltes Gitter oder ein komplex-gekoppeltes Gitter auf.

Erfindungsgemäß kann der BH-DFB-Laser auch aus mehreren Sektionen bestehen, wovon mindestens eine Sektion eine DFB-Sektion ist und einen gekrümmten Wellenleiter aufweist.

In Ausgestaltung können mehrere Sektionen des BH-DFB-Lasers mit einem gemeinsamen elektrischen Kontakt betrieben werden.

Das erfindungsgemäße Prinzip kann auch auf BH-DFB-Laser mit einem vertikal getaperten optischen Wellenleiter übertragen werden.

In einer Ausführungsform der Erfindung ist der optische Wellenleiter in Abschnitte unterschiedlicher Krümmung unterteilt. In jedem Abschnitt ist die effektive Gitterperiode des Diffraktionsgitters für die durchlaufende optische Welle an den lokalen Brechungsindexverlauf angepasst.

Die Erfindung ist für BH-DFB-Laser mit beliebigen optischen Wellen leitern und unterschiedlichen Substratmaterialien, z.B. InP, GaAs oder Si anwendbar.

Die Erfindung wird nachfolgend an einem Ausführungsbeispiel näher erläutert.

Die zugehörigen Zeichnungen zeigen:

Fig. 1:  schematische Darstellung eines getaperten BH-DFB-Lasers nach dem Stand der Technik;

Fig. 2 :  lokaler effektiver Brechungsindex in einer BH-DFB-Laserstruktur nach dem Stand der Technik;

Fig. 3 :  Verlauf der lokalen Bragg-Wellenlänge ohne/mit Anpassung der Gitterperiode;

Fig. 4:  schematische Darstellung eines erfindungsgemäß gekrümmten Wellenleiters mit aktiver Schicht und DFB-Gitter zur lokalen Anpassung der Gitterperiode;

Fig. 5a:  optimaler Verlauf der effektiven Gitterperiode,

Fig. 5b:  optimaler Verlauf des zugehörigen lokalen Krümmungswinkels,

Fig. 6:  typisches Emissionsspektrum des erfindungsgemäßen BH-DFB-Lasers

Die Erfindung kann bei allen BH-DFB-Lasern mit getapertem optischen Wellenleiter realisiert werden, die mindestens aus einem vergrabenen optischen Wellenleiter mit eingebauter aktiver Schicht auf einem Substrat sowie einem integrierten Diffraktionsgitter bestehen. Von besonderer Bedeutung ist das nachfolgend dargestellte Ausführungsbeispiel:

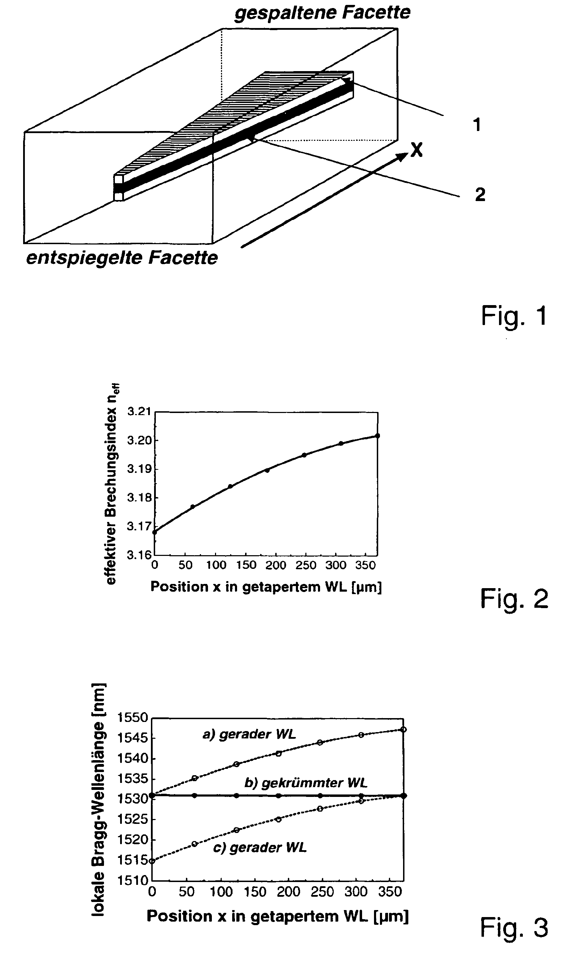

In Fig. 1 ist schematisch der Aufbau eines bekannten BH-DFB-Lasers mit lateral getaperter aktiver Schicht **2** dargestellt. Das DFB-Gitter wird z. B. in den oberen (p-seitigen) der beiden Wellenleiter **1** geätzt. Aufgrund der Taperung der aktiven Schicht **2** ändert sich der effektive Brechungsindex der Struktur lokal.

In Fig. 2 ist der Verlauf des effektiven Brechungsindex für einen 0,37 mm langen bekannten 1550 nm-BH-Lasers an Hand einer Simulationsrechnung dargestellt. Der effektive Brechungsindex $n_{eff}$ ändert sich von der Taperspitze (L = 0 $\mu$m) bis zum Taperende (L = 370 $\mu$m) von 3,168 auf 3,20.

Ohne Anpassung der Gitterperiode ändert sich die lokale Bragg-Wellenlänge von der Taperspitze (L = 0 $\mu$m) bis zum Taperende (L = 370 $\mu$m) um mehr als 15 nm, wie aus Fig. 3 zu entnehmen ist. Die Kurve a) zeigt das Resultat bei geradem Wellenleiter und Anpassung der Gitterperiode für die Taperspitze. Kurve c) zeigt das Resultat bei Anpassung für das Taperende. Daher zeigen solche Laser dann auch einen Multi-Moden-Betrieb. Mit optimaler Anpassung des Wellenleiters durch die erfindungsgemäße Krümmung, wie es Kurve b zeigt, erhält man jedoch unabhängig vom Ort über die gesamte Länge des Wellenleiters exakt die gewünschte konstante Bragg-Wellenlänge.

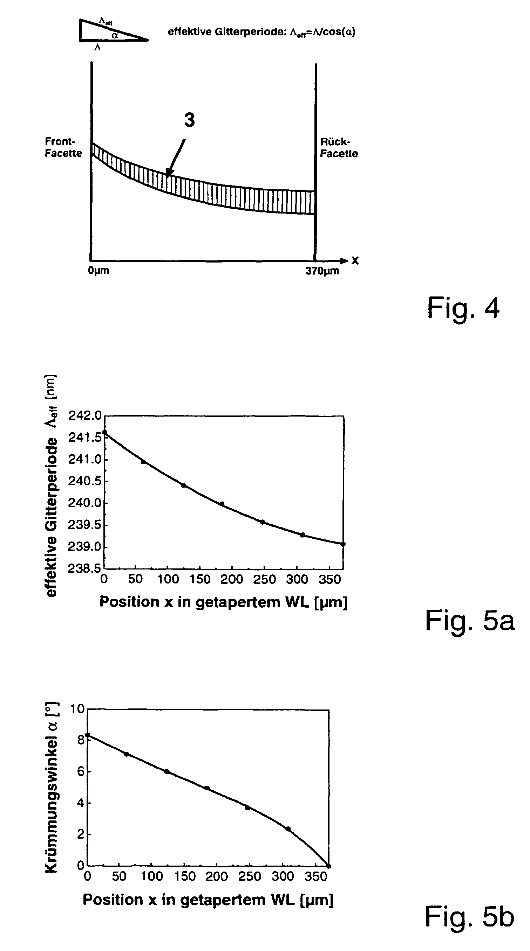

Die Fig. 4 zeigt eine schematische Darstellung des erfindungsgemäß gekrümmten und getaperten Wellenleiters mit aktiver Schicht und DFB-Gitter **3** zur lokalen Anpassung der Gitterperiode. Durch Variation des Winkels $\alpha$ lässt sich die effektive Gitterperiode $\Lambda_{eff}$ kontinuierlich variieren, obwohl nur ein homogenes Gitter mit einer konstanten Gitterperiode A belichtet wird.

Die Berechnung des optimalen Verlaufes der effektiven Gitterperiode $\Lambda_{eff}$ bzw. des Krümmungswinkels $\alpha$ für die in Fig. 4 dargestellte erfindungsgemäße gekrümmte aktive Schicht mit getaperten Wellenleitern und DFB-Gitter **3** erfolgt nach der Formel

$$\Lambda_{eff}(x) = \lambda / 2\, n_{eff}(x)$$

wobei $\Lambda_{eff}$ die effektive Gitterperiode, $\lambda$ die Emissionswellenlänge und $n_{eff}$ der Brechungsindex sind.

Der Verlauf der effektiven Gitterperiode $\Lambda_{eff}$ ist in der Fig. 5a und der Verlauf des Krümmungswinkels $\alpha$ ist in Fig. 5b dargestellt. Krümmungswinkel < 10 ° lassen sich bei der Herstellung der BH-Laser ohne Abänderung der Prozessierungsabfolge technologisch problemlos realisieren und bedeuten daher keinen zusätzlichen Prozessierungsaufwand. Wie Fig. 5b zeigt, ist mit der hier gewählten geeigneten Heterostruktur-Taper-Konfiguration der Wellenleiter an der Frontfacette (x = 0) gegenüber dem Verlauf der aktiven Schicht um ca. 8 ° verkippt.

Aufgrund des Brechungsindexunterschiedes von InP gegen Luft (3,17 : 1) ergibt sich hierdurch eine Entspiegelung der Frontfacette.

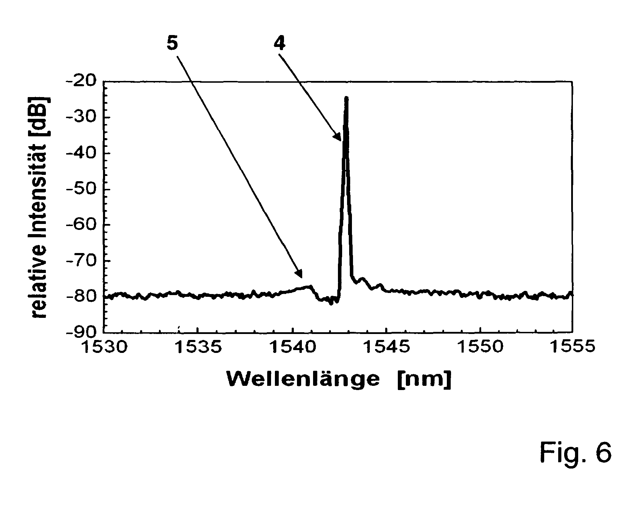

Durch die Kombination der erfindungsgemäß gekrümmten getaperten aktiven Schicht, der Aufweitung des optischen Feldes an der Frontfacette und der geeigneten Schrägstellung der Frontfacette (Entspiegelungseffekt) wird ein Single-Mode-Betrieb des Lasers erreicht. Fig. 6 zeigt ein typisches Emissionsspektrum des erfindungsgemäßen BH-DFB-Lasers. Eine Emission findet nur auf der langwelligen DFB-Mode **4** statt. Die kurzwellige DFB-Mode **5** wird unterdrückt.

Die Erfindung ermöglicht die kostengünstige Herstellung getaperter indexgekoppelter Single-Mode-BH-DFB-Laser mit lateraler Taperung des optischen Wellenleiters und unterschiedlichen aktiven Schichten mittels Elektronenstrahllithographie oder mittels Holographie. Eine zusätzliche Beschichtung der Facetten ist nicht notwendig.

**Patentansprüche**

1. BH-DFB-Laser mit getapertem optischen Wellenleiter zur Aufweitung des optischen Feldes an der Frontfacette, der mindestens aus einem vergrabenen optischen Wellenleiter mit eingebauter aktiver Schicht auf einem Substrat sowie einem integrierten Diffraktionsgitter besteht,
   **dadurch gekennzeichnet, dass**
   das Diffraktionsgitter eine konstante Gitterperiode aufweist und der Wellenleiter (1) mit eingebauter aktiver Schicht (2) derart gekrümmt ausgebildet ist, dass die effektive Gitterperiode $\Lambda_{eff}(x)$ des Diffraktionsgitters für die durchlaufende optische Welle an den lokalen Brechungsindexverlauf $n_{eff}(x)$ nach folgender Bedingung

$$\Lambda_{eff}(x) = \lambda / 2\, n_{eff}(x)$$

   angepasst ist, wobei $\Lambda_{eff}$ die effektive Gitterperiode, $\lambda$ die Emissionswellenlänge und $n_{eff}$ der Brechungsindex ist und die Heterostruktur sowie die Taperung des optischen Wellenleiters dabei so ausgebildet sind, dass der entstehende Winkel zwischen Frontfacette und Verlauf der aktiven Schicht für eine Entspiegelung dieser Facette ausreicht.

2. BH-DFB-Laser nach Anspruch 1,
   **dadurch gekennzeichnet, dass**
   das Gitter ein index-gekoppeltes Gitter ist.

3. BH-DFB-Laser nach Anspruch 2,
   **dadurch gekennzeichnet, dass**
   das Gitter ein index-gekoppeltes Gitter mit einem oder mehreren Phasensprüngen ist.

**4.** BH-DFB-Laser nach Anspruch 1,
**dadurch gekennzeichnet, dass**
das Gitter ein gain-gekoppeltes Gitter ist.

**5.** BH-DFB-Laser nach Anspruch 1,
**dadurch gekennzeichnet, dass**
das Gitter ein komplex-gekoppeltes Gitter ist.

**6.** BH-DFB-Laser nach Anspruch 1,
**dadurch gekennzeichnet, dass**
dieser aus mehreren Sektionen besteht, wovon mindestens eine DFB-Sektion einen gekrümmten Wellenleiter aufweist.

**7.** BH-DFB-Laser nach Anspruch 6,
**dadurch gekennzeichnet, dass**
mehrere Sektionen einen gemeinsamen elektrischen Kontakt aufweisen.

**8.** BH-DFB-Laser nach Anspruch 1,
**dadurch gekennzeichnet, dass**
der optische Wellenleiter vertikal getapert ist.

**9.** BH-DFB-Laser nach Anspruch 1,
**dadurch gekennzeichnet, dass**
der optische Wellenleiter in Abschnitte unterschiedlicher Krümmung unterteilt ist und in jedem Abschnitt die effektive Gitterperiode des Diffraktionsgitters für die durchlaufende optische Welle an den lokalen Brechungsindexverlauf angepasst ist.

**10.** BH-DFB-Laser nach Anspruch 1,
**dadurch gekennzeichnet, dass**
das Substrat ein InP-, GaAs- oder Si-Substrat ist.

**Claims**

**1.** BH-DFB laser, having a tapered optical waveguide for broadening the optical field on the front facet, which consists at least of a buried optical waveguide with a built-in active layer on a substrate as well as an integrated diffraction grating,
**characterised in that**
the diffraction grating has a constant grating period and the waveguide (1) with a built-in active layer (2) is designed to be curved so that the effective grating period $\Lambda_{eff}(x)$ of the diffraction grating for the optical wave passing through is adapted to the local refractive index profile $n_{eff}(x)$ according to the following condition

$$\Lambda_{eff}(x) = \lambda/2n_{eff}(x)$$

where $\Lambda_{eff}$ is the effective grating period, $\lambda$ is the emission wavelength and $n_{eff}$ is the refractive index, and the heterostructure as well as the tapering of the optical waveguide are designed so that the resulting angle between the front facet and the profile of the active layer is sufficient to render this facet anti-reflective.

**2.** BH-DFB laser according to Claim 1,
**characterised in that**
the grating is an index-coupled grating.

**3.** BH-DFB laser according to Claim 2,
**characterised in that**
the grating is an index-coupled grating having one or more phase discontinuities.

**4.** BH-DFB laser according to Claim 1,
**characterised in that**
the grating is a gain-coupled grating.

**5.** BH-DFB laser according to Claim 1,
**characterised in that**
the grating is a complex-coupled grating.

**6.** BH-DFB laser according to Claim 1,
**characterised in that**
it consists of a plurality of sections, of which at least one DFB section comprises a curved waveguide.

**7.** BH-DFB laser according to Claim 6,
**characterised in that**
a plurality of sections comprise a common electrical contact.

**8.** BH-DFB laser according to Claim 1,
**characterised in that**
the optical waveguide is vertically tapered.

**9.** BH-DFB laser according to Claim 1,
**characterised in that**
the optical waveguide is subdivided into segments with different curvature and the effective grating period of the diffraction grating for the optical wave passing through is adapted to the local refractive index profile in each segment.

**10.** BH-DFB laser according to Claim 1, **characterised in that** the substrate is an InP, GaAs or Si substrate.

**Revendications**

**1.** Laser BH-DFB avec guide d'onde optique à raccord en pointe pour élargir le champ optique sur la facette frontale, qui est au moins composé d'un guide d'onde optique enfoui avec couche active intégrée sur un substrat ainsi que d'un réseau de diffraction intégré,
**caractérisé en ce que**

le réseau de diffraction présente une période de réseau constante et le guide d'onde (1) avec couche active (2) intégrée est courbé de sorte que la période de réseau $\Lambda_{eff}(x)$ du réseau de diffraction pour l'onde optique traversante est adaptée à l'évolution de l'indice de réfraction $n_{eff}(x)$ local selon la condition suivante :

$$\Lambda_{eff}(x) = \lambda \ / \ 2 \ n_{eff}(x)$$

$\Lambda_{eff}$ étant la période de réseau effective, $\lambda$ la longueur d'onde d'émission et $n_{eff}$ l'indice de réfraction, et l'hétérostructure ainsi que le raccordement du guide d'onde optique sont alors formés de sorte que l'angle entre la facette frontale et l'évolution locale de la couche active soient suffisants pour un traitement antireflet de cette facette.

**2.** Laser BH-DFB selon la revendication 1, **caractérisé en ce que**
le réseau est un réseau couplé indice.

**3.** Laser BH-DFB selon la revendication 2, **caractérisé en ce que**
le réseau est un réseau couplé indice avec un ou plusieurs sauts de phase.

**4.** Laser BH-DFB selon la revendication 1, **caractérisé en ce que**
le réseau est un réseau couplé gain.

**5.** Laser BH-DFB selon la revendication 1, **caractérisé en ce que**
le réseau est un réseau couplé complexe.

**6.** Laser BH-DFB selon la revendication 1, **caractérisé en ce qu'**
il comprend plusieurs sections, dont au moins une section DFB présente un guide d'onde courbé.

**7.** Laser BH-DFB selon la revendication 6, **caractérisé en ce que**
plusieurs sections présentent un contact électrique commun.

**8.** Laser BH-DFB selon la revendication 1, **caractérisé en ce que**
le guide d'onde optique est raccordé verticalement.

**9.** Laser BH-DFB selon la revendication 1, **caractérisé en ce que**
le guide d'onde optique est divisé en segments de courbure différente et dans chaque segment la période de réseau effective du réseau de diffraction pour l'onde optique traversante est adaptée à l'évolution de l'indice de réfraction local.

**10.** Laser BH-DFB selon la revendication 1, **caractérisé en ce que**
le substrat est un substrat InP, GaAs ou Si.

**gespaltene Facette**

**entspiegelte Facette**

Fig. 1

Fig. 2

Fig. 3

effektive Gitterperiode: $\Lambda_{eff}=\Lambda/cos(\alpha)$

Front-
Facette

Rück-
Facette

3

0µm

370µm

x

**Fig. 4**

**Fig. 5a**

Position x in getapertem WL [µm]

effektive Gitterperiode $\Lambda_{eff}$ [nm]

**Fig. 5b**

Position x in getapertem WL [µm]

Krümmungswinkel $\alpha$ [°]

Fig. 6